# EUROPEAN PATENT SPECIFICATION

(11) **EP 2 543 242 B1**
(45) Date of publication and mention of the grant of the patent: **14.05.2014**
(21) Application number: 11712710.0
(22) Date of filing: 02.03.2011
(51) Int. Cl.: H05K 7/20

(54) **CONDENSER BYPASS FOR TWO-PHASE ELECTRONICS COOLING SYSTEM**
KONDENSATOR-BYPASS FÜR ZWEIPHASIGE ELEKTRONISCHE KÜHLSYSTEME
CONTOURNEMENT AU CONDENSATEUR POUR UN SYSTÈME DE REFROIDISSEMENT D'ÉLECTRONIQUE À DEUX PHASES

(30) Priority: 03.03.2010 US 309909 P
(43) Date of publication of application: 09.01.2013
(73) Proprietor: Parker-Hannifin Corporation, Cleveland, Ohio 44124-4141 (US)
(72) Inventor: LOUVAR, Timothy, Fort Wayne Indiana 46804 (US); TRUMBOWER, Michael, Fort Wayne IN 46816 (US)
(74) Representative: Belcher, Simon James
(86) International application number: PCT/US2011/026773
(87) International publication number: WO 2011/109455

(56) References cited:
- EP-A2- 1 589 299
- US-A1- 2004 168 451
- US-A1- 2009 228 152

## Description

The present invention relates to an electronics cooling system utilizing an outdoor condenser and in particular to a valve controlled bypass circuit is provided to divert flow around the condenser during conditions of cold outdoor ambient temperatures.

Power electronic devices, such as IGBTs, SCRs, etc., continue to achieve higher power switching capacity in a smaller envelope. The amount of heat created by these devices continues to climb as well. Conventional cooling methods include using blowing air, or circulating a water-based fluid through cold plates in thermal contact with the electronic device heat sink. A more recent cooling method utilizes a phase change fluid, or refrigerant, that will evaporate to remove heat from an electronic device heat sink, and condense back to liquid state through heat exchange process with a cold medium (air or water).

US-A-2002/007641 discloses a pumped liquid cooling system which uses a phase change refrigerant. It includes an evaporator, a pump and a liquid receiver which are located in a first environment at a first temperature, and a condenser which is located in a second environment at a second ambient temperature. A refrigerant fluid is circulated through the system by the pump, from the pump to the evaporator, and then to the condenser, and then to the liquid receiver and then back to the pump. Vapour manifolds selectively redirect the flow of fluid to bypass the condenser through a bypass fluid conduit.

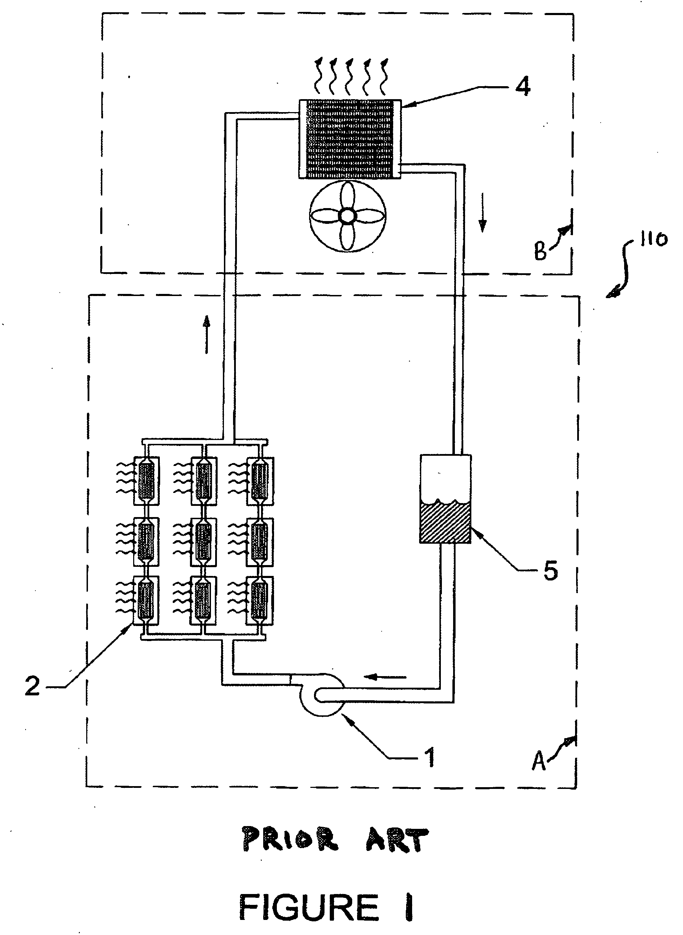

FIG. 1 below shows a diagram of a typical prior art two-phase pumped loop cooling system 110. Liquid refrigerant enters the pump 1, where static pressure is raised and flow is induced. Sub-cooled liquid flows into an evaporator, shown herein as a plurality of cold plates 2, which can be connected in series, or parallel, or both. The cold plates 2 are each mounted in contact with the heat sink of the electronic device. Refrigerant fluid absorbs heat from the electronic device and partially evaporates as it flows through the cold plates 2. Partially evaporated refrigerant fluid is collected in a manifold, and then flows in the condenser heat exchanger 4. The condenser heat exchanger 4 may be air cooled or water cooled and it may be located indoors or outdoors. For the condenser 4 to reject heat to a cold medium, the refrigerant fluid temperature must be above that of the cold medium, or the ambient air. Since the refrigerant is undergoing a condensing process, the refrigerant pressure will follow the refrigerant temperature based on the fluid's saturation pressure-temperature relationship. The refrigerant fluid will leave the condenser 4 as a subcooled liquid, the temperature will be above ambient, and the pressure will correspond to an even higher saturation temperature. The sub-cooled liquid flows into a receiver tank 5, which acts a storage tank to compensate for varying volumes of the fluid in the system 110. The refrigerant fluid volume of liquid and vapour will vary throughout the system 110 based on operating temperatures and heat load, due to varying densities through the operating temperature range.

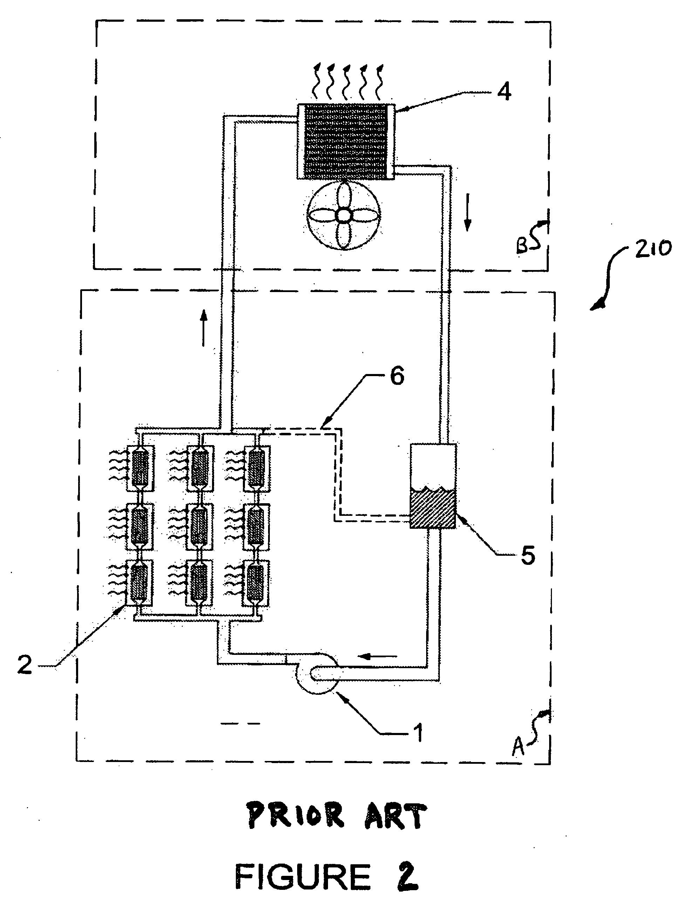

The system 210 shown in FIG. 2 below is similar to that of FIG. 1, except that a liquid return line 6 is added from the cold plate exit manifold to the receiver tank 5. The liquid return line 6 provides a pathway for liquid refrigerant to return to the receiver tank 5, bypassing the condenser 4, while allowing the refrigerant vapour to proceed to the condenser 4. In this system 210 the liquid return line 6 is always open.

It is noted that in the prior art 2-phase cooling systems 110, 210, the system fluid pressure, and hence refrigerant fluid temperature will follow the ambient air temperature at the condenser 4. The system fluid temperature will be at some differential above the ambient air temperature at the condenser 4. When the ambient air temperature at the condenser is the same as the ambient air around the cold plates (such as where the power electronics devices and condenser are both located indoors), there will never be a danger of having moisture condensing out of the air and collecting on the fluid tubing, or pipes, or cold plates, and dripping onto the electronic devices, and damaging the electronics because the fluid temperature will always be above the ambient air dew point.

A problem exists in these prior art systems when the power electronics are located indoors (depicted in FIGS. 1 and 2 as area enclosed by a dashed line and designated A), exposed to warm humid air, and the condenser heat exchanger 4 is located outdoors (depicted in FIGS. 1 and 2 as an area enclosed by a dashed line and designated B) and exposed to extreme cold temperatures. Since the refrigerant fluid temperature will closely follow the condenser ambient air, there will be conditions where the refrigerant fluid entering back indoors will be cold enough to cool the refrigerant fluid conduit surface temperature to a level below the indoor air dew point thereby causing condensation on the fluid conduits and other system components from the moisture of the indoor air. This moisture can drip onto the electronic devices and cause damage from short circuiting.

The invention provides a cooling system comprising:
an evaporator, a pump, and a liquid receiver located in a first environment having a first ambient temperature,
a condenser located in a second environment having a second ambient temperature,
a refrigerant fluid circulated through the system by the pump by a primary fluid conduit from the pump to the evaporator, to the condenser, to the liquid receiver, and back to the pump, and
a pressure control valve adapted to selectively redirect fluid flow to bypass the condenser through a bypass fluid conduit located in the first environment, the pressure control valve having a predetermined pressure set-point, and allowing fluid flow to the condenser when the pressure of the fluid entering the valve from the evaporator, measured in the evaporator outlet line, is greater than the pressure set-point, the valve preventing fluid flow to the condenser and allowing fluid flow to bypass the condenser through a bypass fluid conduit located in the first environment when the pressure of the fluid entering the valve from the evaporator, measured in the evaporator outlet line, is less than the pressure set-point.

The invention also provides a cooling system comprising:
an evaporator, a pump, and a liquid receiver located in a first environment having a first ambient temperature,
a condenser located in a second environment having a second ambient temperature,
a refrigerant fluid circulated through the system by the pump by a primary fluid conduit from the pump to the evaporator, to the condenser, to the liquid receiver, and back to the pump, and
a valve operable to redirect fluid flow from the evaporator to the liquid receiver through a bypass fluid conduit located in the first environment as needed in order to keep the fluid temperature within the first environment above a dew point of the first ambient temperature, the valve being a pressure control valve which has a predetermined pressure set-point, the valve allowing fluid flow to the condenser when the pressure of the fluid entering the valve from the evaporator, measured in the evaporator outlet line, is greater than the pressure set-point, the valve preventing fluid flow to the condenser and allowing fluid flow to bypass the condenser through the bypass fluid conduit when the pressure of the fluid entering the valve from the evaporator, measured in the evaporator outlet line, is less than the pressure set-point.

Embodiments of this invention will now be described in further detail with reference to the accompanying drawings, in which:
FIG. 1 is a schematic of a prior art cooling system;
FIG. 2 is a schematic of another prior art cooling system;
FIG. 3 is a schematic of a cooling system utilizing a pressure control valve;
FIG. 4 is a schematic of another cooling system utilizing a pressure control valve;
FIG. 5 is a schematic of still another cooling system utilizing a pressure control valve;
FIG. 6 is a schematic of another cooling system utilizing an electronic control valve; and
FIG. 7 is a schematic of another cooling system utilizing solenoid valves.

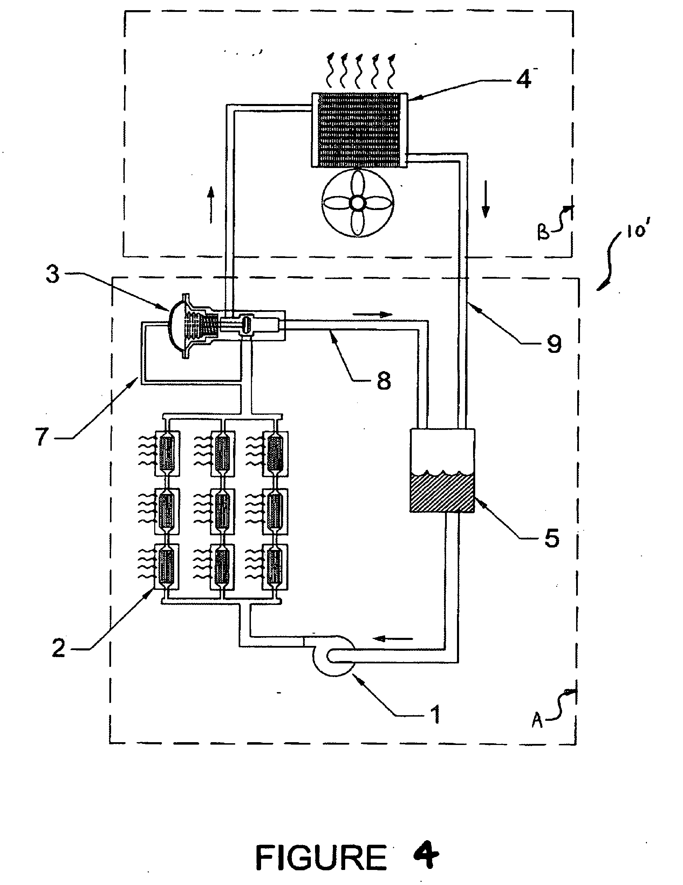

Referring to the drawings, FIG. 3 shows a first embodiment of the cooling system of the present invention. The system 10 comprises an evaporator 2, a pump 1, and a liquid receiver 5 located in a first environment A having a first ambient temperature. The system 10 includes a condenser 4 located in a second environment B having a second ambient temperature. A refrigerant fluid is circulated through the system 10 by the pump 1 by a primary fluid conduit 21 to the evaporator 2, to the condenser 4, to the liquid receiver 5, and back to the pump 1. The evaporator 2 is shown as a plurality of cold plates which can be mounted in the system 10 in series, in parallel, or both. The cold plates of the evaporator 2 are each mounted in thermal contact with the heat sink of an electronic device. Refrigerant fluid absorbs heat from the electronic device and partially evaporates as it flows through the cold plates of the evaporator 2.

The system 10 also comprises a valve 3 operable to redirect fluid flow from the evaporator 2 to the liquid receiver 5 through a bypass fluid conduit 8 located in the first environment A as needed in order to keep the fluid temperature within the first environment A above a dew point of the first ambient temperature. The valve 3 as shown is a pressure control valve 3. The partially evaporated refrigerant fluid leaving the evaporator 2 will enter the pressure control valve 3. The pressure control valve 3 will divert refrigerant fluid to flow either to the outdoor condenser 4 or to the bypass circuit 8, based on a pressure feedback line 7 in comparison to a predetermined control valve internal set point. The pressure feedback line 7 is fluidly connected to the evaporator outlet line. The control valve 3 will divert flow to the condenser 4 when the fluid pressure leaving the evaporator 2 is higher than the internal set point. Otherwise, the control valve 3 will divert flow to the bypass circuit 8 and around the condenser 4 when the fluid pressure leaving the evaporator 2 is lower than the internal set point. The control valve internal set point will be set to a pressure corresponding to a fluid saturation temperature that is above the highest expected dew point for the indoor conditions. During operation, the refrigerant fluid will build up pressure based on the amount of heat entering the cold plate evaporators 2. If the system pressure is below the control valve set point, the refrigerant fluid will circulate into the bypass circuit 8, and into the receiver tank 5, and back to the pump 1. Thus, the refrigerant fluid will bypass the condenser 4 and not be exposed to extreme cold air temperatures. The refrigerant fluid temperature will always be above the indoor air dew point, because it is not exposed to any cold medium. With continued heat load on the cold plate evaporators 2, the refrigerant fluid temperature and pressure will exceed the control valve set point. With cold plate fluid pressure exceeding control valve set point, the control valve shuts off flow to the bypass circuit 8 and allows flow to the condenser 4. Depending on the heat load and outdoor ambient conditions, the system pressure may continue to rise (as in a warm outdoor temperature), or it may begin to fall again (as for a cold outdoor temperature). If the outdoor temperature is warm, the system pressure will settle at a steady-state point based on a temperature differential between the fluid saturation temperature and ambient air temperature. This is a similar operation to the prior art systems. If the outdoor temperature is extremely cold, the control valve 3 will selectively allow flow to the condenser 4. As the refrigerant fluid is exposed to the very cold outdoor air temperature, the fluid temperature and system pressure will eventually drop. The system pressure could drop below the control valve set point, and refrigerant flow will again be diverted around the condenser 4 and into the bypass circuit 8. Thus, the system self regulates, keeping the fluid pressure at or above the control valve internal set point. Therefore, refrigerant fluid temperature will always be above the indoor air dew point, due to the control valve regulating flow either to the outdoor condenser 4 or around it. There will be no danger of having moisture collect on the refrigerant tubing due to condensation, even with an outdoor condenser 4.

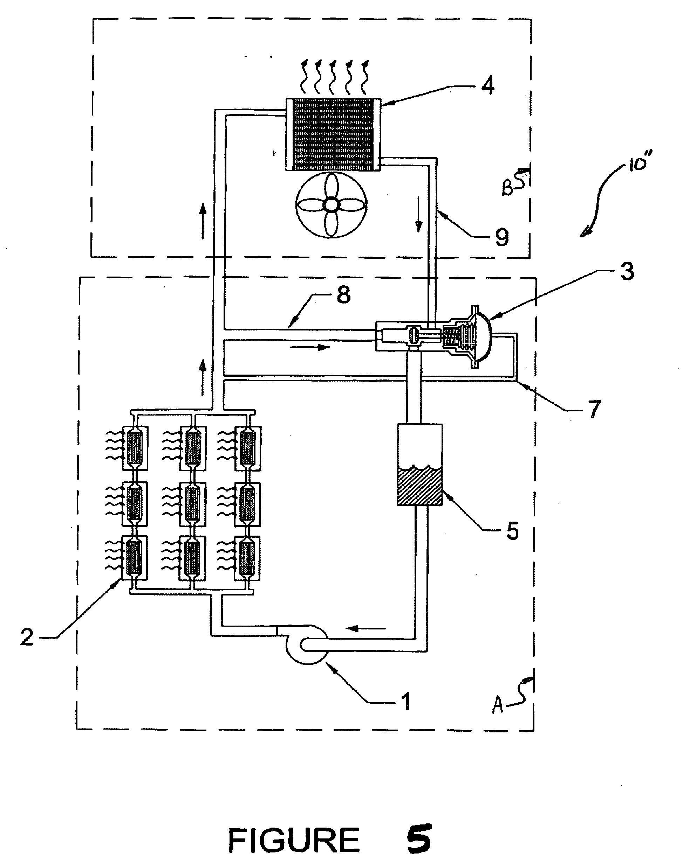

FIG. 4 shows another embodiment of the system similar to that of FIG. 3 except on where the bypass circuit is routed. In this embodiment the bypass circuit 8' is routed directly into the top of the receiver tank 5. Likewise the refrigerant fluid tube 9 leaving the condenser 4 is also routed directly into the top of the receiver tank 5. This embodiment of the invention allows liquid refrigerant that has accumulated in the condenser to drain back into the receiver tank, thus providing more sub-cooling at the pump inlet.

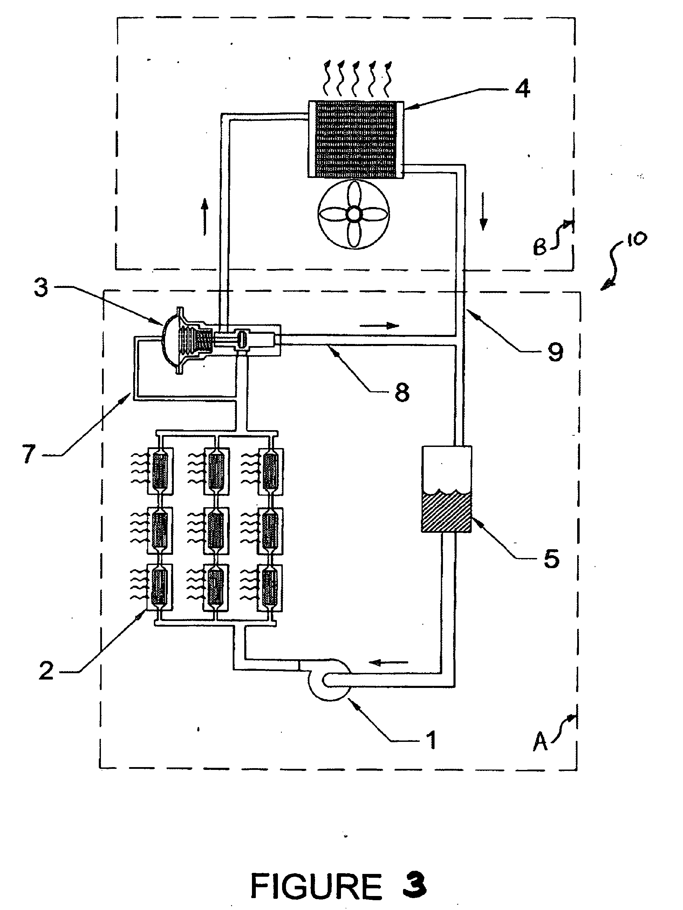

FIG. 5 shows another embodiment of the invention. For this embodiment, the control valve 3 is placed between the condenser 4 and the receiver tank 5. It accomplishes the same purpose in that it allows flow either from the condenser 4, or around it, based on fluid pressure leaving the cold plates 2. Fluid pressure leaving the cold plates 2 that is above the control valve internal set point will cause the control valve 3 to allow flow from the condenser 4 and shut-off the bypass circuit 8. Fluid pressure leaving the cold plates 2 below the control valve internal set point will cause the control valve 3 to block flow from the condenser 4 and allow flow from the bypass circuit 8.

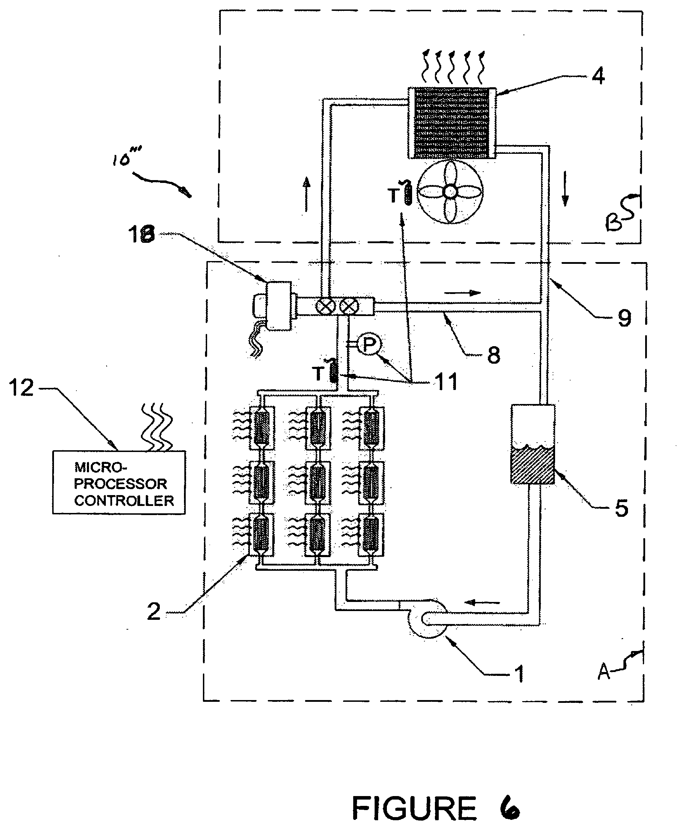

FIG. 6 shows another embodiment of a cooling system 10"' of the invention. The control valve 18 is in the same position as the system described in FIG. 3. However, for this system 10"', the control valve 18 is an electronic control valve. The cooling system 10"' will have a micro-processor controller 12 that reads inputs from various sensors 11 that monitor the refrigerant fluid temperatures and pressures and possibly ambient air temperature. The micro-processor controller 12 will use various fluid temperatures and pressures in an algorithm and will determine whether the control valve 18 should divert flow to the condenser 4 or to the bypass circuit 8 around it. The micro-processor controller 12 will send an electronic signal to the control valve 18 to properly position it.

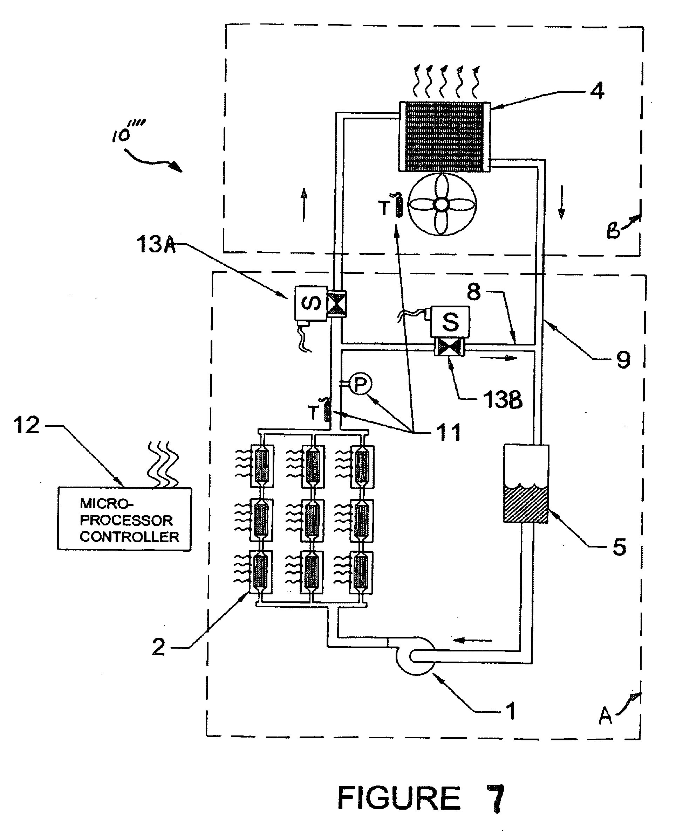

FIG. 7 shows another embodiment of a cooling system 10"" of the invention. The control valve could actually be split into two, 2-way valves 13, such as a solenoid valve; one valve 13A at the condenser inlet circuit, and one valve 13B on the bypass circuit as shown in FIG. 7. The solenoid valves 13 are controlled by a micro-processor controller 12, or could be simply wired in series to a pressure switch 11 located at the cold plate exit line. One solenoid valve 13 would be normally-closed, and the other solenoid valve 13 would be normally-open. High pressure at the cold plate exit line would activate the pressure switch, which would close bypass circuit solenoid valve 13B, and open the condenser entering line solenoid valve 13A.

## Claims

1. A cooling system comprising:
an evaporator (2), a pump (1), and a liquid receiver (5) located in a first environment (A) having a first ambient temperature,
a condenser (4) located in a second environment (B) having a second ambient temperature,
a refrigerant fluid circulated through the system by the pump by a primary fluid conduit (21) from the pump to the evaporator, to the condenser, to the liquid receiver, and back to the pump, and
a valve (3, 18, 13) adapted to selectively redirect fluid flow to bypass the condenser through a bypass fluid conduit (8) located in the first environment,
**characterised in that** the valve (3, 18, 13) is a pressure control valve which has a predetermined pressure set-point, the valve allowing fluid flow to the condenser (4) when the pressure of the fluid entering the valve from the evaporator (2), measured in the evaporator outlet line, is greater than the pressure set-point, the valve preventing fluid flow to the condenser and allowing fluid flow to bypass the condenser through the bypass fluid conduit (8) when the pressure of the fluid entering the valve from the evaporator, measured in the evaporator outlet line, is less than the pressure set-point.

2. The cooling system as claimed in claim 1, in which the valve (3, 18, 13) is located in the first environment (A) downstream of the evaporator (2) and upstream of the condenser (4).

3. The cooling system as claimed in claim 1, in which the valve (3, 18, 13) is located in the first environment (A) downstream of the condenser (4) and upstream of the liquid receiver (5).

4. The cooling system as claimed in any of claims 1 to 3, in which the valve is an electronic control valve (18) that is operated by a micro-processor controller in response to a pressure sensor (11), optionally in combination with a temperature sensor (11).

5. The cooling system as claimed in any of claims 1 to 4, in which the bypass fluid conduit (8) is connected to the primary fluid conduit (21) between the condenser (4) and the liquid receiver (5).

6. The cooling system as claimed in any of claims 1 to 5, in which the bypass fluid conduit (8) is directly connected to the liquid receiver (5).

7. A cooling system comprising:
an evaporator (2), a pump (1), and a liquid receiver (5) located in a first environment (A) having a first ambient temperature,
a condenser (4) located in a second environment (B) having a second ambient temperature,
a refrigerant fluid circulated through the system by the pump by a primary fluid conduit (21) from the pump to the evaporator, to the condenser, to the liquid receiver, and back to the pump, and
a valve (3, 18, 13) operable to redirect fluid flow from the evaporator to the liquid receiver through a bypass fluid conduit (8) located in the first environment as needed in order to keep the fluid temperature within the first environment above a dew point of the first ambient temperature,
**characterised in that** the valve is a pressure control valve which-has a predetermined pressure set-point, the valve allowing fluid flow to the condenser when the pressure of the fluid entering the valve from the evaporator, measured in the evaporator outlet line, is greater than the pressure set-point, the valve preventing fluid flow to the condenser and allowing fluid flow to bypass the condenser through the bypass fluid conduit when the pressure of the fluid entering the valve from the evaporator, measured in the evaporator outlet line, is less than the pressure set-point.

8. The cooling system as claimed in claim 7, in which the valve (3, 18, 13) is located in the first environment (A) downstream of the evaporator (2) and upstream of the condenser (4).

9. The cooling system as claimed in claim 7, in which the valve (3, 18, 13) is located in the first environment (A) downstream of the condenser (4) and upstream of the liquid receiver (5).

10. The cooling system as claimed in any of claims 7 to 9, in which the valve is an electronic control valve (18) that is operated by a micro-processor controller in response to a pressure sensor (11), optionally in combination with a temperature sensor (11).

11. The cooling system as claimed in any of claims 7 to 10, in which the bypass fluid conduit (8) is connected to the primary fluid conduit (21) between the condenser (4) and the liquid receiver (5).

12. The cooling system as in any of claims 7 to 11, in which the bypass fluid conduit is directly connected to the liquid receiver.

## Patentansprüche

1. Ein Kühlsystem mit
einem Verdampfer (2), einer Pumpe (1) und einem Flüssigkeitsbehälter (5), die in einer ersten Umgebung (A) mit einer ersten Umgebungstemperatur angeordnet sind,
einem Kondensator (4), der in einer zweiten Umgebung (B) mit einer zweiten Umgebungstemperatur angeordnet ist,
einem Kühlfluid, das über einen primären Fluidkanal (21) von der Pumpe zu dem Verdampfer, zu dem Kondensator, zu dem Flüssigkeitsbehälter und zurück zu der Pumpe von der Pumpe durch das System zirkuliert wird, und
einem Ventil (3, 18, 13), das dazu eingerichtet ist, selektiv einen Fluidstrom umzuleiten, um den Kondensator über einen in der ersten Umgebung angeordneten Bypass-Fluidkanal (8) zu umgehen,
**dadurch gekennzeichnet, dass** das Ventil (3, 18, 13) ein Drucksteuerventil ist, welches einen vorgegebenen Drucksollwert hat, wobei das Ventil einen Fluidstrom zum Kondensator (4) erlaubt, wenn der Druck des vom Verdampfer (2) in das Ventil eintretenden Fluids, gemessen in der Verdampferauslassleitung, größer ist als der Drucksollwert, und wobei das Ventil einen Fluidstrom zum Kondensator verhindert und einem Fluidstrom erlaubt, den Kondensator über den Bypass-Fluidkanal (8) zu umgehen, wenn der Druck des vom Verdampfer in das Ventil eintretenden Fluids, gemessen in der Verdampferauslassleitung, geringer ist als der Drucksollwert.

2. Das Kühlsystem nach Anspruch 1, bei welchem das Ventil (3, 18, 13) in der ersten Umgebung (A) stromab des Verdampfers (2) und stromauf des Kondensators (4) angeordnet ist.

3. Das Kühlsystem nach Anspruch 1, bei welchem das Ventil (3, 18, 13) in der ersten Umgebung (A) stromab des Kondensators (4) und stromauf des Flüssigkeitsbehälters (5) angeordnet ist.

4. Das Kühlsystem nach einem der Ansprüche 1 bis 3, bei welchem das Ventil ein elektronisches Steuerventil (18) ist, das von einer Mikroprozessorsteuerung als Reaktion auf einen Drucksensor (11), optional in Verbindung mit einem Temperatursensor (11), betrieben wird.

5. Das Kühlsystem nach einem der Ansprüche 1 bis 4, bei welchem der Bypass-Fluidkanal (8) zwischen dem Kondensator (4) und dem Flüssigkeitsbehälter (5) mit dem primären Fluidkanal (21) verbunden ist.

6. Das Kühlsystem nach einem der Ansprüche 1 bis 5, bei welchem der Bypass-Fluidkanal (8) direkt mit dem Flüssigkeitsbehälter (5) verbunden ist.

7. Ein Kühlsystem mit
einem Verdampfer (2), einer Pumpe (1) und einem Flüssigkeitsbehälter (5), die in einer ersten Umgebung (A) mit einer ersten Umgebungstemperatur angeordnet sind,
einem Kondensator (4), der in einer zweiten Umgebung (B) mit einer zweiten Umgebungstemperatur angeordnet ist,
einem Kühlfluid, das über einen primären Fluidkanal (21) von der Pumpe zu dem Verdampfer, zu dem Kondensator, zu dem Flüssigkeitsbehälter und zurück zu der Pumpe von der Pumpe durch das System zirkuliert wird, und
einem Ventil (3, 18, 13), das in der Lage ist, einen Fluidstrom je nach Bedarf über einen in der ersten Umgebung angeordneten Bypass-Fluidkanal (8) von dem Verdampfer zu dem Flüssigkeitsbehälter umzuleiten, um die Fluidtemperatur innerhalb der ersten Umgebung über einem Taupunkt der ersten Umgebungstemperatur zu halten,
**dadurch gekennzeichnet, dass** das Ventil ein Drucksteuerventil ist, welches einen vorgegebenen Drucksollwert hat, wobei das Ventil einen Fluidstrom zum Kondensator erlaubt, wenn der Druck des vom Verdampfer in das Ventil eintretenden Fluids, gemessen in der Verdampferauslassleitung, größer ist als der Drucksollwert, und wobei das Ventil einen Fluidstrom zum Kondensator verhindert und einem Fluidstrom erlaubt, den Kondensator über den Bypass-Fluidkanal zu umgehen, wenn der Druck des vom Verdampfer in das Ventil eintretenden Fluids, gemessen in der Verdampferauslassleitung, geringer ist als der Drucksollwert.

8. Das Kühlsystem nach Anspruch 7, bei welchem das Ventil (3, 18, 13) in der ersten Umgebung (A) stromab des Verdampfers (2) und stromauf des Kondensators (4) angeordnet ist.

9. Das Kühlsystem nach Anspruch 7, bei welchem das Ventil (3, 18, 13) in der ersten Umgebung (A) stromab des Kondensators (4) und stromauf des Flüssigkeitsbehälters (5) angeordnet ist.

10. Das Kühlsystem nach einem der Ansprüche 7 bis 9, bei welchem das Ventil ein elektronisches Steuerventil (18) ist, das von einer Mikroprozessorsteuerung als Reaktion auf einen Drucksensor (11), optional in Verbindung mit einem Temperatursensor (11), betrieben wird.

11. Das Kühlsystem nach einem der Ansprüche 7 bis 10, bei welchem der Bypass-Fluidkanal zwischen dem Kondensator (4) und dem Flüssigkeitsbehälter (5) mit dem primären Fluidkanal (21) verbunden ist.

12. Das Kühlsystem nach einem der Ansprüche 7 bis 11, bei welchem der Bypass-Fluidkanal direkt mit dem Flüssigkeitsbehälter verbunden ist.

## Revendications

1. Système de refroidissement comprenant :
un évaporateur (2), une pompe (1) et un récepteur de liquide (5) situés dans un premier environnement (A) ayant une première température ambiante,
un condenseur (4) situé dans un deuxième environnement (B) ayant une deuxième température ambiante,
un fluide réfrigérant mis en circulation à travers le système par la pompe par un conduit de fluide primaire (21) depuis de la pompe vers l'évaporateur, vers le condenseur, vers le récepteur de liquide et à nouveau vers la pompe, et
une soupape (3, 18, 13) adaptée pour rediriger de manière sélective l'écoulement de fluide pour contourner le condenseur à travers un conduit de fluide de dérivation (8) situé dans le premier environnement,
**caractérisé en ce que** la soupape (3, 18, 13) est une soupape de commande de pression qui a une valeur de consigne de pression prédéterminée, la soupape permettant l'écoulement de fluide vers le condenseur (4) lorsque la pression du fluide entrant dans la soupape en provenance de l'évaporateur (2), mesurée dans la ligne de sortie d'évaporateur, est supérieure à la valeur de consigne de pression, la soupape empêchant l'écoulement de fluide vers le condenseur et permettant l'écoulement de fluide pour contourner le condenseur à travers le conduit de fluide de dérivation (8) lorsque la pression du fluide entrant dans la soupape en provenance de l'évaporateur, mesurée dans la ligne de sortie de l'évaporateur, est inférieure à la valeur de consigne de pression.

2. Système de refroidissement tel que revendiqué dans la revendication 1, dans lequel la soupape (3, 18, 13) est située dans le premier environnement (A) en aval de l'évaporateur (2) et en amont du condenseur (4).

3. Système de refroidissement tel que revendiqué dans la revendication 1, dans lequel la soupape (3, 18, 13) est située dans le premier environnement (A) en aval du condenseur (4) et en amont du récepteur de liquide (5).

4. Système de refroidissement tel que revendiqué dans l'une des revendications 1 à 3, dans lequel la soupape est une soupape de commande électronique (18) qui est actionnée par une unité de commande à microprocesseur en réponse à un capteur de pression (11), éventuellement en combinaison avec un capteur de température (11).

5. Système de refroidissement tel que revendiqué dans l'une des revendications 1 à 4, dans lequel le conduit de fluide de dérivation (8) est relié au conduit de fluide primaire (21) entre le condenseur (4) et le récepteur de liquide (5).

6. Système de refroidissement tel que revendiqué dans l'une des revendications 1 à 5, dans lequel le conduit de fluide de dérivation (8) est directement relié au récepteur de liquide (5).

7. Système de refroidissement comprenant :
un évaporateur (2), une pompe (1) et un récepteur de liquide (5) situés dans un premier environnement (A) ayant une première température ambiante,
un condenseur (4) situé dans un deuxième environnement (B) ayant une deuxième température ambiante,
un fluide réfrigérant mis en circulation à travers le système par la pompe par un conduit de fluide primaire (21) depuis la pompe vers l'évaporateur, vers le condenseur, vers le récepteur de liquide et à nouveau vers à la pompe, et
une soupape (3, 18, 13) pouvant fonctionner pour rediriger l'écoulement de fluide en provenance de l'évaporateur vers le récepteur de liquide à travers un conduit de fluide de dérivation (8) situé dans le premier environnement selon les besoins pour maintenir la température de fluide à l'intérieur du premier environnement au-dessus d'un point de rosée de la première température ambiante,
**caractérisé en ce que** la soupape est une soupape de commande de pression qui a une valeur de consigne de pression prédéterminée, la soupape permettant l'écoulement de fluide vers le condenseur lorsque la pression du fluide entrant dans la soupape en provenance de l'évaporateur, mesurée dans la ligne de sortie d'évaporateur, est supérieure à la valeur de consigne de pression, la soupape empêchant l'écoulement de fluide vers le condenseur et permettant l'écoulement de fluide pour contourner le condenseur à travers le conduit de fluide de dérivation lorsque la pression du fluide entrant dans la soupape en provenance de l'évaporateur, mesurée dans la ligne de sortie d'évaporateur, est inférieure à la valeur de consigne de pression.

8. Système de refroidissement tel que revendiqué dans la revendication 7, dans lequel la soupape (3, 18, 13) est située dans le premier environnement (A) en aval de l'évaporateur (2) et en amont du condenseur (4).

9. Système de refroidissement tel que revendiqué dans la revendication 7, dans lequel la soupape (3, 18, 13) est située dans le premier environnement (A) en aval du condenseur (4) et en amont du récepteur de liquide (5).

10. Système de refroidissement tel que revendiqué dans l'une des revendications 7 à 9, dans lequel la soupape est une soupape de commande électronique (18) qui est actionnée par une unité de commande à microprocesseur en réponse à un capteur de pression (11), éventuellement en combinaison avec un capteur de température (11).

11. Système de refroidissement tel que revendiqué dans l'une des revendications 7 à 10, dans lequel le conduit de fluide de dérivation (8) est relié au conduit de fluide primaire (21) entre le condenseur (4) et le récepteur de liquide (5).

12. Système de refroidissement tel que revendiqué dans l'une des revendications 7 à 11, dans lequel le conduit de fluide de dérivation est relié directement au récepteur de liquide.
